# EUROPEAN PATENT SPECIFICATION

(11) **EP 2 326 751 B1**
(45) Date of publication and mention of the grant of the patent: **03.04.2013**
(21) Application number: 09805315.0
(22) Date of filing: 08.06.2009
(51) Int. Cl.: H05K 3/42, C25D 5/02

(54) **DIRECT METALLIZATION PROCESS**
DIREKTMETALLISIERUNG
PROCÉDÉ DE MÉTALLISATION DIRECTE

(30) Priority: 06.08.2008 US 186727
(43) Date of publication of application: 01.06.2011
(73) Proprietor: MacDermid, Incorporated, Waterbury, CT 06702 (US)
(72) Inventor: RETALLICK, Richard, C., West Hartford CT 06107 (US); RAU, Werner, 71083 Herrenberg (DE); SCHUSTER, Josef, 71159 Motzingen (DE)
(74) Representative: Jenkins, Peter David
(86) International application number: PCT/US2009/046546
(87) International publication number: WO 2010/016968

(56) References cited:
- US-A- 5 139 642
- US-A- 5 738 776
- US-A- 5 754 928
- US-A1- 2008 076 245
- US-B1- 6 231 619

## Description

### FIELD OF THE INVENTION

The present invention is directed to improved methods of fixing the carbon dispersion coating on surfaces of printed wiring boards.

### BACKGROUND OF THE INVENTION

Printed wiring boards (also known as printed circuit boards or PWB's) are generally laminated material comprised of two or more plates or foils of copper, which are separated from each other by a layer of nonconducting material. Although copper is generally used as the electroplating metal, other metals such as nickel, gold, palladium, silver and the like can also be electroplated. The nonconducting layer or layers are preferably organic materials such as epoxy resins impregnated with glass fibers. The nonconducting layer may also be comprised of thermosetting resins, thermoplastic resins, and mixtures thereof, with or without reinforcing materials such as fiberglass and fillers. Suitable materials are generally well known to those skilled in the art.

In many printed wiring board designs, the electrical pathway or pattern requires a connection between the separated copper plates at certain points in the pattern, which may be accomplished by drilling holes at desired locations through the laminate of copper plates and the nonconducting layer to connect the separate metal plates. Typical hole diameters in the printed wiring boards generally range from between about 0.5 and about 10 millimeters in diameter. The holes are then metallized to form a connection between the conductive materials, which is typically accomplished by plating. In order to avoid the step of electroless plating of the through-holes, which requires several steps including pre-activation, activation with a suitable activator, application of an accelerator, electroless metal (i.e., copper) deposition and several rinses before the electroplating step can occur, various "direct metallization" processes have been developed as is well known in the art and is described, for example in U.S. Patent No. 5,759,378 to Ferrier et al., the subject matter of which is herein incorporated by reference in its entirety.

The steps of the direct metallization process are described briefly below:

After drilling the through holes, the holes may be deburred to make the hole walls relatively smooth. In the case of multilayer printed wiring boards, it may also be desirable to subject the boards to a desmear or etchback operation to clean the inner copper interfacing surfaces of the through holes. Suitable preparative operations are well known to those skilled in the art and include, by way of example and not limitation, conventional permanganate desmearing processes.

Once the surfaces of through holes have been made relatively smooth for plating, the PWB may be subjected to a precleaning process in order to place the printed wiring board in condition for receiving a conductive carbon dispersion. For example, the printed wiring board may be placed in a cleaner bath for about 1 to 10 minutes at a temperature of about 45°C to 70°C to remove grease and other impurities from the hole wall surfaces.

Thereafter, the PWB is rinsed to remove excess cleaner from the board and contacted with a conditioner solution. A preferred method of contacting with a conditioner is dipping the cleaned PWB into a room temperature aqueous conditioner bath for a period of time (e.g., about 1-10 minutes). The conditioner solution ensures that substantially all of the hole wall glass/epoxy surfaces are properly prepared to accept a continuous layer of conductive carbon particles.

The liquid carbon dispersion is then applied to, or contacted with, the conditioned PWB. This dispersion contains three critical ingredients - a source of carbon, such as carbon black and/or graphite, one or more surfactants capable of dispersing the carbon black and a liquid dispersing medium such as water. Preferred methods of contacting the dispersion to the PWB include immersion and spraying. Other methods are also known to those skilled in the art.

In preparing the liquid carbon dispersion, the three critical ingredients and any other preferred ingredients are thoroughly mixed together to form a stable dispersion. This may be accomplished by subjecting a concentrated form of the liquid carbon dispersion to ball milling, colloidal milling, high-shear milling, ultrasonic techniques, or by high speed mixing or other standard blending techniques. The thoroughly mixed carbon black dispersion is then diluted with more water with agitation to the desired concentration for the working bath.

The source of carbon is generally selected from graphite, carbon black and combinations thereof. Many types of carbon blacks may be used including commonly available furnace blacks.

Liquid dispersing mediums for the liquid carbon dispersion include water and polar organic solvents, including lower alcohols (C₁-C₄) such as methanol, ethanol, isopropanol, and isobutanol; polyhydric alcohols such as glycols (i.e. triethylene glycols); either alcohols such as cellosolve; organic acids, such as formic acid and acetic acid; acid derivatives such as trichloroacetic acid; and sulfonic acids such as methane sulfonic acid; aldehydes such as acetaldehyde; ketones such as acetone; aromatic solvents such as toluene and mineral spirits; aprotic halogenated hydrocarbons such as dichlorofluoromethane and dichlorodifluoromethane (FREON®); dimethylformamide (DMF); N-methylpyrrolidone; dimethylsulfoxide (DMSO); and esters of carboxylic acids such as methylformate, ethylacetate, and cellosolve acetate. The preferred liquid dispersing medium is water, and especially deionized water which is free of calcium, fluorine, iodine, and other impurities normally found in tap water, in order to minimize interference of foreign ions during the subsequent electroplating step.

The dispersant also contains a surfactant capable of dispersing the carbon black or graphite in the liquid dispersing medium. One or more surfactants are added to the dispersion in order to enhance the wetting ability and stability of the carbon black and permit maximum penetration by the carbon black within the pores and fibers of the nonconducting layer. Suitable wetting agents include anionic, nonionic, and cationic surfactants (or combination thereof such as amphoteric surfactants). The surfactants are chosen so as to be soluble, stable and preferably nonfoaming in the liquid carbon dispersion. The preferred type of surfactant depends mainly on the pH of the dispersion. Suitable surfactants are well known to those skilled in the art and are described for example in U.S. Patent No. 5,759,378 to Ferrier et al., the subject matter of which is herein incorporated by reference in its entirety.

The amount of carbon in the dispersion is typically less than about 4% by weight of the dispersion, preferably, less than about 2% by weight. In the same regard, the solids content (i.e. all of the ingredients other than the liquid dispersing medium) is preferably less than 10% by weight of the dispersion.

The dispersion may also contain a strong basic material such as an alkaline hydroxide, including alkali metal hydroxides such as potassium hydroxide, sodium hydroxide, and lithium hydroxide, and ammonium hydroxide. Sufficient alkaline hydroxide may be added to the liquid dispersion in a proportion sufficient to increase the pH of the resulting carbon-containing dispersion to between about 10 and about 14, and preferably between about 10 to about 12.

The liquid dispersion is typically placed in a suitably agitated vessel and the printed wiring board to be treated is immersed in, sprayed with or otherwise contacted with the liquid dispersion. The temperature of the liquid dispersion in an immersion bath is maintained in the range of between about 15°C and about 35°C, while the conditioned printed wiring board is immersed therein. The period of immersion generally ranges from about 1 to 10 minutes. In a conveyorized process, a dwell time of 20 to 60 seconds may be employed. During immersion, the liquid carbon-containing dispersion penetrates the holes of the printed wiring board and wets and contacts the glass fiber as well as the epoxy resin which forms the components of the insulating layer. The immersed board is then removed from the liquid carbon black-containing dispersion bath.

The carbon-coated printed wiring board may then be subjected to a fixing step prior to drying in order to remove excess carbon dispersion from the surface of the PWB and to make the carbon dispersion more workable. Fixing may be accomplished in at least two different ways, i.e., by a chemical fixing method or by a physical fixing method. The fixing step is typically carried out after said carbon dispersion contacting step, without an intervening drying step.

In chemical fixing, a fixing solution is applied to the surfaces that have been wetted by the carbon dispersion. The fixing solution removes excessive carbon composition deposits, and thus smooths the carbon coating on the recess surfaces by eliminating lumps and by making the coating more uniform.

In physical fixing, the recesses or other surfaces of the substrate, which have been wetted with the carbon dispersion, are subjected to a mechanical force to remove excess deposits of the carbon coating before it is dried. The mechanical force may be applied in a wide variety of ways. For example, a fluid jet may be used to contact the surfaces that have been coated with the carbon dispersion. The jet blows away any excess accumulation of the carbon deposit, and particularly any occlusions of the carbon dispersion, which can in some instances block through holes or other recesses. The fixing process removes excessive carbon deposits and smoothes the carbon coating on the recess surfaces by eliminating lumps and by making the coating more uniform. Fixing may also crosslink the first monolayer of carbon which is directly attached to the substrate or an aqueous organic binding agent associated with the coating. The resulting coating has a low electrical resistance and is tenacious enough to be plated and exposed to molten solder without creating voids or losing adhesion. In the alternative, the air jet can be provided in the form of an ``air knife" - i.e., a curtain of moving air. The curtain is formed of air or another gas traveling perpendicular to the surface of the wiring board, through which the wiring board is passed to blow out the recesses and thus fix the carbon dispersion, more. The curtain of air may also be heated, thus further assisting in drying the substrate.

After the carbon dispersion is applied and fixed, the carbon-coated portion of the substrate typically is dried, thus depositing a dry carbon coating on the substrate, which acts to more fully crosslink the carbon coating.

Thereafter, the carbon coated printed wiring board is subjected to a step where substantially all (i.e., more than about 95% by weight) of the water in the applied dispersion is removed and a dried deposit containing carbon black and/or graphite is left in the holes and on other exposed surfaces of the nonconducting layer. This may be accomplished by various methods including evaporation at room temperature, vacuum, heating the board for a short time at an elevated temperature, an air knife, or by other equivalent means that would generally be know to one skilled in the art.

To insure complete coverage of the hole walls, the procedure of immersing the board in the carbon dispersion and then drying may be repeated one or more times.

Once this step is completed, the PWB is completely coated with the carbon black and/or graphite dispersions, because the dispersions not only coat the drilled hole surfaces, which is desirable, but also entirely coat the copper plate or foil surfaces which is undesirable. Thus prior to many subsequent operations all of the carbon black and/or graphite must be removed from the copper plate or foil surfaces.

In many processes, the removal process involves "microetching," which is carried out by exposing the carbon coated printed wiring board or other substrate to an etchant that removes a small amount of copper from copper clad surfaces of the substrate without appreciably attacking carbon coating on the non-copper coated portions of the substrate.

The mechanism by which the microetch works is not by attacking the carbon black material or the graphite material deposited on the copper foil directly, but rather attacking exclusively the first few atomic layers of copper directly below which provides the adhesion for the coating. Thus, the fully coated board is immersed in or otherwise contacted with the microetch solution to "flake" off the carbon black and the graphite from the copper surfaces in the form of micro-flakelets. These micro-flakelets are then removed from the microetch bath by filtering or other means known in the art.

After the microetch step and a subsequent water rinse, the PWB may proceed to the photoimaging process and later be electroplated or be directly electroplated.

The treated printed wiring board may be electroplated by immersing the PWB in a suitable electroplating bath to apply a copper coating on the prepared hole walls of the nonconducting layer.

The printed wiring board is then removed from the copper electroplating bath and is washed and dried to provide a board which may be further processed. For example, the PWB may be subjected to a tin-lead electroplating operation.

Direct metallization processes typically utilize automated horizontal processing equipment to apply the conductive carbon coating to the substrate, including steps in the process described above.

During the fixing step which follows the deposition of conductive carbon on the printed wiring board, excess solution that is removed in the blow-off chamber can remain airborne through the chamber and redeposit on the surface of the substrate, thus creating uneven coverage of the carbon dispersion on the substrate. It would be therefore be desirable to replace the blow-off chamber with another means of removing excess solution that is capable of effectively removing excess solution from the substrate and the chamber and that also prevents redeposition of the solution onto the substrate.

In addition, it would also be desirable to provide an improved means for removing excess carbon dispersion solution remaining on the surface of the substrate to minimize the requirement for microetching.

US 6,231,619 describes a process for electroplating a substrate by coating the substrate with a coating of carbonaceous particles and then drying by passing between resilient rollers and an air knife. US 5,139,642 describes a process for electroplating a conductive metal layer comprising pretreating with a carbon black dispersion, followed by a graphite dispersion before the electroplating step. US 5,754,928 discloses a squeegee apparatus for removing excess developer liquid from an imaging substrate. US 2006/0076245 discloses a process for preparing a non-conductive substrate for electroplating.

### SUMMARY OF THE INVENTION

It is an object of the present invention to provide an improved means for removing excess carbon dispersion from a printed wiring board during a direct metallization process.

It is another object of the present invention to provide an improved means for removing excess carbon dispersion which minimizes or eliminates redeposition of the solution on the substrate.

It is still another object of the present invention to provide cleaner copper surfaces on the printed wiring board to minimize the microetching requirement.

To that end, the present invention relates generally to an improved direct metallization process comprising the steps of:
a) applying a conductive carbon dispersion to surfaces of a substrate comprising conductive and non-conductive portions;
b) contacting the substrate with at least one non-absorbent roller to remove excess carbon-containing dispersion from the substrate; and/or
c) passing the substrate through a vacuum extraction chamber to extract excess carbon dispersion remaining on surfaces of the substrate.

### DETAILED DESCRIPTION OF THE PREFERRED EMBODIMENTS

The present invention relates generally to improved methods for removing excess carbon dispersion solution from the surfaces of the printed wiring board substrate while at the same time preventing the excess solution from redepositing on surfaces of the printed wiring board. The present invention also relates generally to an improved process which minimizes the microetching requirement by providing cleaner copper surface on the printed wiring board or other similar substrate.

In one embodiment, the present invention relates generally to an improved direct metallization process comprising the steps of:
a) applying a conductive carbon dispersion to surfaces of a substrate comprising conductive and non-conductive portions;
b) contacting the substrate with at least one non-absorbent roller to remove excess carbon-containing dispersion from the substrate; and/or
c) passing the substrate through a vacuum extraction chamber to extract excess carbon dispersion remaining on surfaces of the substrate.

The step of applying a conductive carbon dispersion to surfaces of a substrate is discussed above and can be accomplishing using various conductive carbon-containing dispersions known to those skilled in the art. In addition, while the substrate may be a printed wiring board containing conductive and non-conductive portions, other substrates containing similar conductive and non-conductive portions may also be treated using the process of the invention. Also, while the conductive portion of the substrate is typically copper, other conductive metals or a metal alloys would also be usable in the practice of the invention.

The present invention utilizes one or more non-absorbent rollers that are configured to remove excess carbon dispersion from a substantially planar surface of the substrate. That is, the at least one non-absorbent roller is brought into contact with the substantially planar surface of the substrate and pressure is applied to urge the roller against the substrate. The roller is then passed or rolled over at least a portion and preferably over the entire substantially planar surface of the substrate to squeegee off excess carbon dispersion. Because the roller is non-absorbent and is not readily deformable, the roller stays on top of the substantially planar surface of the substrate and acts to push or "squeegee" off the excess material on the substantially planar surface of the substrate.

What is meant by "non-absorbent" rollers in the present invention is that the at least one roller does not absorb water or other materials. In addition, the non-absorbent rollers are also not readily deformable, whereby the rollers remain on the surface of the substrate and act to "squeegee" away excess material from the surface of the substrate. In this manner, cleaner copper surfaces are realized which minimizes the requirements of the subsequent microetch process. The non-absorbent rollers of the invention are made from a material such as molded polyurethane that absorbs little or no carbon dispersion. Other similar materials that are suitable for roller making and are non-absorbent would also be usable in the practice of the invention and would generally be known to those skilled in the art. Typically, the non-absorbent roller is constructed to have a hardness of at least 40 degrees Shore (A), preferably about 15-18 degrees Shore (A).

It is noted that rollers have previously been suggested for use in removing material from openings such as through holes in printed circuit boards, as discussed for example in U.S. Patent No. 6,231,619 to Florio et al., the subject matter of which is herein incorporated by reference in its entirety. However, in this process, the rollers are absorbent rollers that deform under pressure to remove material from through hole openings and have a hardness of only about 35 to 70 durometer. In contrast, the present invention uses a non-absorbent roller that acts as a squeegee on a surface of the substrate to provide cleaner conductive portions (i.e., cleaner copper surfaces) to minimize the microetch requirement.

Once the carbon dispersion has been applied to the surface of the substrate and the excess solution removed by squeegeeing with the one or more rollers, the substrate may be further processed.

Previously, excess carbon dispersion remaining on surfaces of the substrate, including through holes drilled therein has typically been passed through a blow-off chamber to remove excess solution from the surfaces and holes of the substrate. One of the difficulties with the blow off operation is that the solution can remain airborne throughout the chamber and can then redeposit onto the surface of the substrate. Thus, in one embodiment, the present invention replaces the blow off chamber with a vacuum extraction chamber to remove excess solution from the surfaces and holes of the substrate while at the same time preventing the solution from redepositing on the substrate.

The vacuum extraction chamber is situated adjacent to the carbon depositing chamber. Once the printed wiring board has been coated with the carbon dispersion and the excess coating on the surface removed by the squeegeeing roller, the printed wiring board is cycled into the vacuum extraction chamber, where a vacuum is drawn for a suitable period of time to remove the excess carbon-containing solution remaining on the printed wiring board. Typically, the vacuum is drawn for a period of about 0.01 to about 1 minute. The present invention is designed to prevent the redeposition of carbon black on to the copper substrate surface, thereby reducing the reliance of the microetch step to remove it. Once the excess solution has been removed, the present process uses a subsequent drying step to dry the solution remaining on the substrate.

Finally, while the present invention has been described above as utilizing both non-absorbent rollers and a vacuum extraction chamber to remove excess carbon dispersion from surfaces of the printed wiring board or other similar substrate, it should be understood that the non-absorbent rollers and the vacuum chamber can be used separately as well. That is, one or the other of the non-absorbent rollers and the vacuum chamber can be used to remove excess carbon dispersion from the surface of the printed wiring board. While the inventors of the present invention have found that the combination of the non-absorbent rollers and vacuum chamber may provide a better result with respect to cleaning the surface, the use of each of these steps separately also yields good results.

In addition, the present invention can be applied to any direct metallization process that requires the removal of a coating on copper or other surfaces prior to electroplating.

Finally, while the invention has been described above with reference to specific embodiments thereof, it is apparent that many changes, modifications, and variations can be made without departing from the scope of the appended claims.

## Claims

1. A method of providing a carbon dispersion coating on surfaces of a substrate, said substrate having conductive and non-conductive portions, in a direct metallization process, the method comprising the steps of:
a) contacting the substrate with the carbon dispersion to coat the substrate with the carbon-containing dispersion;
b) moving a non-absorbent roller over at least a portion of a substantially planar surface of the substrate to remove excess carbon dispersion from the substantially planar surface of the substrate; and thereafter;
c) passing the substrate through a vacuum extraction chamber to extract excess carbon dispersion remaining on surfaces of the substrate.

2. The method according to claim 1, wherein the non-absorbent roller comprises molded polyurethane.

3. The method according to claim 2, wherein the non-absorbent roller has a hardness of at least 40 degrees Shore (A).

4. The method according to claim 2, wherein the non-absorbent roller has a hardness of about 15-18 degrees Shore (A).

5. The method according to claim 1, wherein the non-absorbent roller is not readily deformable.

6. The method according to claim 1, wherein the carbon dispersion comprises a source of carbon, one or more surfactants capable of dispersing the source of carbon and a liquid dispersing medium.

7. The method according to claim 6, wherein the carbon-containing dispersion is applied by immersing the substrate in the dispersion or by spraying the dispersion on the substrate.

8. The method according to claim 1, wherein the substrate is a printed wiring board.

9. The method according to claim 8, wherein the printed wiring board has through holes drilled therethrough.

10. The method according to claim 1, further comprising the step of removing substantially all of the carbon dispersion from the conductive portions of the substrate.

11. The method according to claim 10, wherein the step of removing comprises the step of contacting the substrate with an etchant capable of microetching the conductive portions of the substrate.

## Patentansprüche

1. Verfahren zur Bereitstellung einer Kohlenstoffdispersionsbeschichtung auf Oberflächen eines Substrats in einem Direktmetallisierungsprozess, wobei substrat leitende und nicht leitende Abschnitte aufweist, wobei das Verfahren die Schritte:
a) Kontaktieren des Substrats mit der Kohlenstoffdispersion zum Beschichten des Substrats mit der Kohlenstoffhaltigen Dispersion;
b) Bewegen einer nicht-absorbierenden Walze über zumindest einen Abschnitt einer im Wesentlichen ebenen Oberfläche des Substrats, um so die überschüssige Kohlenstoffdispersion von der im Wesentlichen ebenen Oberfläche des Substrats zu entfernen; und danach
c) Führen des Substrats durch eine Vakuumextraktionskammer, um so überschüssige Kohlenstoffdispersion, die auf Oberflächen des Substrats verbleibt, zu extrahieren, umfasst.

2. Verfahren nach Anspruch 1, wobei die nicht-absorbierende Walze geformtes Polyurethan umfasst.

3. Verfahren nach Anspruch 2, wobei die nicht-absorbierende Walze eine Härte von mindestens 40° Shore (A) hat.

4. Verfahren nach Anspruch 2, wobei die nicht-absorbierende Walze eine Härte von etwa 15 - 18° Shore (A) hat.

5. Verfahren nach Anspruch 1, wobei die nicht-absorbierende Walze nicht ohne weiteres verformbar ist.

6. Verfahren nach Anspruch 1, wobei die Kohlenstoffdispersion eine Kohlenstoffquelle, ein oder mehrere oberflächenaktive Mittel, die die Kohlenstoffquelle dispergieren können, und ein flüssiges Dispersionsmedium fasst.

7. Verfahren nach Anspruch 6, wobei die Kohlenstoff-haltige Dispersion durch Tauchen des Substrats in die Dispersion oder durch Sprühen der Dispersion auf das Substrat aufgebracht wird.

8. Verfahren nach Anspruch 1, wobei das Substrat eine Leiterplatte ist.

9. Verfahren nach Anspruch 8, wobei die Leiterplatte Durchgangslöcher aufweist, die durch sie hindurch gebohrt sind.

10. Verfahren nach Anspruch 1, ferner umfassend den schritt der Entfernung von im Wesentlichen der gesamten Kohlenstoffdispersion von leitenden Abschnitten des Substrats.

11. Verfahren nach Anspruch 10, wobei der Schritt der Entfernung den Schritt des Kontaktieren des Substrats mit einem Ätzmittel, welches die leitenden Abschnitte des Substrats mikroätzen kann, umfasst.

## Revendications

1. Procédé de fourniture d'une dispersion de carbone pouf revêtir des surfaces d'un substrat, le substrat comprenant des parties conductrices et des parties conductrices, dans un procédé de métallisation directe, ce procédé comprenant les étapes suivantes :
a) mettre le substrat au contact de la dispersion de carbone pour revêtir le substrat de la dispersion contenant du carbone ;
b) déplacer un rouleau non absorbant sur au moins une partie d'une surface sensiblement plane du substrat pour enlever la dispersion de carbone en excès de la surface sensiblement plane du substrat, et, ensuite
c) faire passer le substrat par une chambre d'extraction sous vide pour extraire la dispersion de carbone en excès restant sur les surfaces du substrat.

2. Procédé selon la revendication 1, dans lequel le rouleau non absorbant comprend du polyuréthanne moulé.

3. Procédé selon la revendication 2, dans lequel le rouleau non absorbant a une dureté d'au moins 40 degrés Shore (A).

4. Procédé selon la revendication 2, dans lequel le rouleau non absorbant a une dureté d'environ 15 à 18 degrés Shore (A)

5. Recédé selon la revendication 1, dans lequel le rouleau non n'est facilement réformable.

6. Procédé selon la revendication 1, dans lequel la dispersion de carbone comprend une source de carbone, un ou plusieurs surfactants aptes à disperser la source carbone, et un milieu de dispersion liquide.

7. Procédé selon la revendication 6, dans lequel la dispersion contenant du carbone est appliquée en immergeant le substrat la dispersion ou en pulvérisant la dispersion sur le substrat.

8. Procédé selon la revendication 1, dans lequel le substrat est une carte de circuit imprimé.

9. Procédé selon la revendication 8, dans lequel la carte de circuit imprimé est percée de trous.

10. Procédé selon la revendication 1, comprenant en outre l'étape consistant à enlever sensiblement toute la dispersion de carbone des parties conductrices du substrat.

11. Procédé selon la revendication 10, dans lequel l'étape d'enlèvement comprend l'étape consistant à mettre le substrat en contact avec un produit d'attaque apte à micro-attaquer les parties conductrices du substrat.
